# EUROPÄISCHE PATENTSCHRIFT

(11) **EP 3 078 649 B1**
(45) Veröffentlichungstag und Bekanntmachung des Hinweises auf die Patenterteilung: **18.10.2017**
(21) Anmeldenummer: 15163098.5
(22) Anmeldetag: 10.04.2015
(51) Int. Cl.: C04B 41/87, C04B 41/89, F01D 5/28

(54) **VERBUNDKERAMIK MIT KORROSIONSSCHUTZSCHICHT UND VERFAHREN ZUR HERSTELLUNG**
COMPOSITE CERAMIC WITH CORROSION PROTECTION LAYER AND METHOD FOR PRODUCING SAME
CÉRAMIQUE COMPOSITE DOTÉE D'UNE COUCHE DE PROTECTION CONTRE LA CORROSION ET SON PROCÉDÉ DE PRODUCTION

(43) Veröffentlichungstag der Anmeldung: 12.10.2016
(73) Patentinhaber: MTU Aero Engines AG, 80995 München (DE)
(72) Erfinder: Schneiderbanger, Stefan, 85221 Dachau (DE); Barl, Nicole, 81245 München (DE); Walter, Heinrich, 86316 Friedberg (DE)

(56) Entgegenhaltungen:
- EP-A1- 1 403 233
- US-A- 5 411 762

## Beschreibung

### HINTERGRUND DER ERFINDUNG

### GEBIET DER ERFINDUNG

Die vorliegende Erfindung betrifft ein Bauteil einer Strömungsmaschine aus einem Verbundwerkstoff mit einer Keramikmatrix und einer auf dem Bauteil angeordneten Korrosionsschutzschicht sowie ein Verfahren zur Herstellung eines derartigen Bauteils einer Strömungsmaschine.

### STAND DER TECHNIK

Verbundkeramiken mit einer keramischen Matrix, in die insbesondere keramische Fasern eingelagert sind, also sogenannte CMC (Ceramic Matrix Composites) - Werkstoffe, sind für Bauteile von Strömungsmaschinen, wie von stationären Gasturbinen oder Flugtriebwerken, interessante Werkstoffe, da sie gegenüber aggressiven Umgebungsbedingungen und hohen Temperaturen weitgehend beständig sind und darüber hinaus hohe Festigkeitswerte auch bei hohen Temperaturen aufweisen.

Derartige faserverstärkte Keramiken werden üblicherweise aus Aluminiumoxid, Siliciumcarbid, Kohlenstoff oder Mullit gebildet, wobei die eingelagerten Fasern aus den gleichen Materialien gebildet sein können. Insbesondere können Fasern und Matrix eine identische oder ähnliche chemische Zusammensetzung aufweisen, wie beispielsweise durch Kohlenstofffasern verstärkte Kohlenstoffe, durch Siliciumcarbidfasern verstärkte Siliciumcarbide oder durch Aluminiumoxidfasern verstärkte Aluminiumoxide. Allerdings sind auch Mischungen möglich, wie beispielsweise durch Kohlenstofffasern verstärkte Siliciumcarbide.

Obwohl diese Materialien in vielen Fällen bereits eine ausreichende Hochtemperaturbeständigkeit in sauerstoffhaltigen Atmosphären aufweisen, kann es bei bestimmten Umgebungsbedingungen, beispielsweise bei wasserdampfhaltigen Atmosphären, zu einer Schädigung des Materials kommen, wenn sich beispielsweise bei Verbundkeramiken mit Siliciumcarbid in Anwesenheit von Wasserdampf flüchtige Siliciumhydroxid - Verbindungen bilden.

Aus diesem Grund ist es erforderlich die oben beschriebenen Verbundkeramiken durch eine Korrosionsschutzschicht vor aggressiven Atmosphären und korrosiven Medien zu schützen.

Aus dem Stand der Technik ist es bereits bekannt, Schutzschichten auf der Basis von Barium - Strontium - Aluminosilikaten (BSAS) oder auf Basis von Silikaten aus seltenen Erden (SE) (SE-SiO5 oder SE-Si2O7) vorzusehen. Allerdings weisen Schutzschichten auf Basis dieser Materialien den Nachteil auf, dass sie zu Glasphasen neigen, die keinen ausreichenden Schutz bilden und auch bei diesen Schichten das Problem besteht, dass sie bei Anwesenheit von Wasserdampf flüchtige Siliciumhydroxid - Verbindungen bilden können.

Aus der Druckschrift EP 1 403 233 A ist ein Bauteil für eine Strömungsmaschine bekannt, das ein Silicium enthaltendes Substrat und eine BSAS-Barriere-Schicht umfasst. Aus der Druckschrift US 5 411 762 A ist ein Verfahren zur Herstellung eines keramischen Materials bekannt, wobei keramische Material auf einem Material basiert, das dem System angehört, welches Silicium, Aluminium, Sauerstoff und Stickstoff umfasst.

### OFFENBARUNG DER ERFINDUNG

### AUFGABE DER ERFINDUNG

Es ist deshalb Aufgabe der vorliegenden Erfindung, ein Bauteil für eine Strömungsmaschine aus einer Verbundkeramik mit einer auf der Verbundkeramik angeordneten Korrosionsschutzschicht sowie ein entsprechendes Verfahren zu dessen Herstellung bereitzustellen, bei dem die Nachteile des Standes der Technik gemindert bzw. behoben sind und insbesondere das entsprechende Bauteil unempfindlich gegenüber aggressiven Atmosphären und korrosiven Medien ist, wobei insbesondere ein Schutz gegenüber der Zersetzung durch wasserdampfhaltige Atmosphären gegeben sein soll. Darüber hinaus soll das Bauteil einfach und reproduzierbar herstellbar sein, sowie zuverlässig einsetzbar sein.

### TECHNISCHE LÖSUNG

Diese Aufgabe wird gelöst durch ein Bauteil mit den Merkmalen des Anspruchs 1 sowie ein Verfahren mit den Merkmalen des Anspruchs 7. Vorteilhafte Ausgestaltungen sind Gegenstand der abhängigen Ansprüche.

Die vorliegende Erfindung schlägt vor, auf einem Bauteil aus einem Verbundwerkstoff mit einer Keramikmatrix eine Korrosionsschutzschicht vorzusehen, die 50 - 80 Gew.% Silicium, 12 - 30 Gew.% Stickstoff, 2 - 8 Gew.% Sauerstoff, 2 - 8 Gew.% Aluminium und 0 - 3 Gew.% mindestens eines Erdalkalimetalls umfasst. Es hat sich überraschend gezeigt, dass eine Korrosionsschutzschicht mit der oben angegebenen chemischen Zusammensetzung eine gute Korrosionsbeständigkeit insbesondere auch bei Anwesenheit von Wasserdampf in der Atmosphäre liefert.

Insbesondere kann die Korrosionsschutzschicht 60 - 70 Gew.%, vorzugsweise 64 - 66 Gew.% Silicium, 15 - 25 Gew.%, vorzugsweise 18 - 22 Gew.% Stickstoff, 3 - 7 Gew.%, insbesondere 4 - 6 Gew.% Sauerstoff, 3 - 7 Gew.%, vorzugsweise 4 - 6 Gew.% Aluminium und 0,1 - 2,5 Gew.%, vorzugsweise 1 - 2 Gew.% eines Erdalkalimetalls umfassen.

Der Verbundwerkstoff mit einer Keramikmatrix kann insbesondere ein Faserverbundwerkstoff mit eingelagerten Keramikfasern sein, wobei die Keramikmatrix aus mindestens einer Komponente der Gruppe gebildet sein kann, die Kohlenstoff, Siliciumcarbid, Aluminiumoxid und Mullit umfasst.

Die Keramikfasern können aus mindestens einer Komponente der Gruppe gebildet sein, die ebenfalls Kohlenstoff, Siliciumcarbid, Aluminiumoxid und Mullit umfasst.

Zwischen der Korrosionsschutzschicht und dem Verbundwerkstoff kann zusätzlich eine Haftvermittlerschicht angeordnet sein, die die Haftung der Korrosionsschutzschicht auf dem Bauteil aus dem Verbundwerkstoff verbessert. Die Haftvermittlerschicht kann aus einem Material aus der Gruppe gebildet sein, die Mullit, Silicium und eine Mischung aus dem Material der Korrosionsschutzschicht und Mullit umfasst. Insbesondere kann die Haftvermittlerschicht als Gradientenschicht ausgebildet sein, bei der beispielsweise an der Seite zum Bauteil aus dem Verbundwerkstoff nahezu 100% Mullit vorliegt und der Anteil des Materials der Korrosionsschutzschicht in der Haftvermittlerschicht zur Seite der Korrosionsschutzschicht zunimmt und bis auf 100% steigt.

Die Korrosionsschutzschicht kann durch unterschiedliche Prozesse auf dem Halbzeug aus dem Verbundwerkstoff aufgebracht werden, wie beispielsweise Plasmaspritzen, Suspensionsplasmaspritzen, Niederdruckplasmaspritzen, physikalische Gasphasenabscheidung (PVD), chemische Gasphasenabscheidung (CVD) sowie Aufbringen eines entsprechenden Schlickers durch Streichen, Walzen oder Spritzen mit anschließendem Sintern oder durch Aufschmelzen oder Schmelztauchen.

### KURZBESCHREIBUNG DER FIGUREN

Die beigefügten Zeichnungen zeigen in rein schematischer Weise in
- Fig. 1: eine perspektivische Darstellung einer Schaufel einer Strömungsmaschine, bei der die vorliegende Erfindung eingesetzt werden kann,
- Fig. 2: eine Schnittansicht durch einen Teil einer ersten Ausführungsform eines erfindungsgemäßen Bauteils und
- Fig. 3: eine Schnittansicht durch einen Teil einer zweiten Ausführungsform eines erfindungsgemäßen Bauteils.

### AUSFÜHRUNGSBEISPIELE

Weitere Vorteile, Kennzeichen und Merkmale der vorliegenden Erfindung werden bei der nachfolgenden detaillierten Beschreibung der Ausführungsbeispiele deutlich, wobei die Erfindung nicht auf diese Ausführungsbeispiele beschränkt ist.

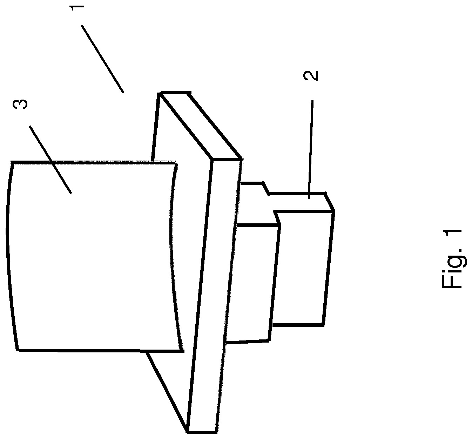

Die Fig. 1 zeigt rein schematisch in einer perspektivischen Darstellung eine Schaufel, wie sie in einer Strömungsmaschine eingesetzt werden kann. Die Schaufel 1 weist einen Schaufelfuß 2 auf, der in eine entsprechende Aufnahme einer Scheibe eingesetzt werden kann, wobei die Scheibe Teil eines Rotors ist, sodass durch Drehung des Rotors die Schaufel 1 in der Strömungsmaschine gedreht wird, um in der Strömungsmaschine fließendes Fluid zu verdichten oder durch das Fluid angetrieben zu werden. Entsprechend weist die Schaufel 1 ein Schaufelblatt 3 auf, welches im Strömungskanal der Strömungsmaschine angeordnet ist und dort unter Umständen hohen Temperaturen und aggressiven Medien ausgesetzt ist.

Gemäß der vorliegenden Erfindung kann die Schaufel 1 aus einer Verbundkeramik mit einer Keramikmatrix und eingelagerten keramischen Fasern gebildet sein, welche eine Korrosionsschutzschicht aufweist, um die Verbundkeramik vor aggressiven Medien zu schützen.

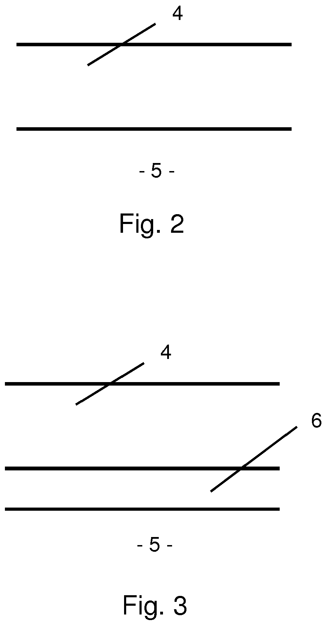

Die Fig. 2 zeigt in einer rein schematischen Darstellung eine teilweise Schnittansicht durch ein entsprechendes Bauteil mit der Verbundkeramik 5 als Substrat für die Korrosionsschutzschicht 4, die die erfindungsgemäße Zusammensetzung mit Silicium, Stickstoff, Sauerstoff, Aluminium und mindestens einem Erdalkalimetall aufweist.

Bei der Ausführungsform der Fig. 3 ist zusätzlich zwischen der Verbundkeramik 5 und der Korrosionsschutzschicht 4 eine Haftvermittlerschicht 6 ausgebildet, die aus Mullit, Silicium oder einer Mischung aus dem Material der Korrosionsschutzschicht 4 und Mullit gebildet sein kann.

Obwohl die vorliegende Erfindung anhand der Ausführungsbeispiele detailliert beschrieben worden ist, ist für den Fachmann selbstverständlich, dass die Erfindung nicht auf diese Ausführungsbeispiele beschränkt ist, sondern dass vielmehr Abwandlungen in der Weise möglich sind, dass einzelne Merkmale weggelassen oder andersartige Kombination von Merkmalen verwirklicht werden können, solange der Schutzbereich der beigefügten Ansprüche nicht verlassen wird. Die vorliegende Offenbarung schließt sämtliche Kombinationen der vorgestellten Einzelmerkmale mit ein.

### BEZUGSZEICHENLISTE

- 1: Schaufel
- 2: Schaufelfuß
- 3: Schaufelblatt
- 4: Korrosionsschutzschicht
- 5: Verbundkeramik
- 6: Haftvermittlerschicht

## Patentansprüche

1. Bauteil einer Strömungsmaschine aus einem Verbundwerkstoff (5) mit einer Keramikmatrix und einer Korrosionsschutzschicht (4),
**dadurch gekennzeichnet, dass**
die Korrosionsschutzschicht umfasst:
50 - 80 Gew.% Silicium,
12 - 30 Gew.% Stickstoff,
2 - 8 Gew.% Sauerstoff,
2 - 8 Gew.% Aluminium und
0 - 3 Gew.% mindestens eines Erdalkalimetalls.

2. Bauteil nach Anspruch 1,
**dadurch gekennzeichnet, dass**
die Korrosionsschutzschicht (4) umfasst:
60 - 70 Gew.%, insbesondere 64 - 66 Gew.% Silicium,
15 - 25 Gew.%, insbesondere 18 - 22 Gew.% Stickstoff,
3 - 7 Gew.%, insbesondere 4 -6 Gew.% Sauerstoff,
3 - 7 Gew.%, insbesondere 4 -6 Gew.% Aluminium und
0,1 - 2,5 Gew.%, insbesondere 1 - 2 Gew.% mindestens eines Erdalkalimetalls.

3. Bauteil nach einem der vorhergehenden Ansprüche,
**dadurch gekennzeichnet, dass**
der Verbundwerkstoff (5) mit Keramikmatrix ein Faserverbundwerkstoff mit eingelagerten Keramikfasern ist.

4. Bauteil nach einem der vorhergehenden Ansprüche,
**dadurch gekennzeichnet, dass**
die Keramikmatrix aus mindestens einer Komponente der Gruppe gebildet ist, die Kohlenstoff, Siliziumkarbid, Aluminiumoxid und Mullit umfasst.

5. Bauteil nach einem der Ansprüche 3 oder 4,
**dadurch gekennzeichnet, dass**
die Keramikfasern aus mindestens einer Komponente der Gruppe gebildet ist, die Kohlenstoff, Siliziumkarbid, Aluminiumoxid und Mullit umfasst.

6. Bauteil nach einem der vorhergehenden Ansprüche,
**dadurch gekennzeichnet, dass**
zwischen dem Verbundwerkstoff (5) und der Korrosionsschutzschicht (4) mindestens eine Haftvermittlerschicht (6) angeordnet ist, die insbesondere gebildet ist aus einem Material aus der Gruppe, die Mullit, Silicium und eine Mischung aus dem Material der Korrosionsschutzschicht und Mullit umfasst.

7. Verfahren zur Herstellung eines Bauteils einer Strömungsmaschine, bei welchem ein Halbzeug aus einem Verbundwerkstoff mit einer Keramikmatrix bereitgestellt wird,
**dadurch gekennzeichnet, dass**
auf dem Halbzeug eine Korrosionsschutzschicht (4) abgeschieden wird, die umfasst:
50 - 80 Gew.% Silicium,
12 - 30 Gew.% Stickstoff,
2 - 8 Gew.% Sauerstoff,
2 - 8 Gew.% Aluminium und
0 - 3 3 Gew.% mindestens eines Erdalkalimetalls.

8. Verfahren nach Anspruch 7,
**dadurch gekennzeichnet, dass**
die Korrosionsschutzschicht (4) durch mindestens einen Prozess aus der Gruppe aufgebracht wird, die Plasmaspritzen, Suspensionsplasmaspritzen, Niederdruckplasmaspitzen, physikalische Gasphasenabscheidung, chemische Gasphasenabscheidung, Auschmelzen, Schmelztauchen, Streichen, Walzen, Spritzen und Sintern umfasst.

## Claims

1. A component of a turbomachine composed of a composite material (5) having a ceramic matrix and a corrosion protection layer (4),
**characterized in that**
the corrosion protection layer comprises:
50 to 80 wt% silicon,
12 to 30 wt% nitrogen,
2 to 8 wt% oxygen,
2 to 8 wt% aluminum, and
0 to 3 wt% at least one alkaline-earth metal.

2. The component according to claim 1,
**characterized in that**
the corrosion protection layer (4) comprises:
60 to 70 wt%, in particular, 64 to 66 wt% silicon,
15 to 25 wt%, in particular, 18 to 22 wt% nitrogen,
3 to 7 wt%, in particular, 4 to 6 wt% oxygen,
3 to 7 wt%, in particular, 4 to 6 wt% aluminum, and
0.1 to 2.5 wt%, in particular, 1 to 2 wt% at least one alkaline-earth metal.

3. The component according to any of the preceding claims,
**characterized in that**
the composite material (5) with ceramic matrix is a fiber composite material with embedded ceramic fibers.

4. The component according to any of the preceding claims,
**characterized in that**
the ceramic matrix is formed of at least one component of the group comprising carbon, silicon carbide, aluminum oxide, and mullite.

5. The component according to either of claims 3 or 4,
**characterized in that**
the ceramic fibers are formed of at least one component of the group comprising carbon, silicon carbide, aluminum oxide, and mullite.

6. The component according to any of the preceding claims,
**characterized in that**
at least one adhesion promoter layer (6) is arranged between the composite material (5) and the corrosion protection layer (4), the adhesion promoter layer being composed, in particular, of a metal from the group comprising mullite, silicon, and a mixture of the material of the corrosion protection layer and mullite.

7. A method for producing a component of a turbomachine, in which a semifinished product of a composite material comprising a ceramic matrix is prepared,
**characterized in that**
a corrosion protection layer (4) is deposited on the semifinished product, the corrosion protection layer comprising;
50 to 80 wt% silicon,
12 to 30 wt% nitrogen,
2 to 8 wt% oxygen,
2 to 8 wt% aluminum, and
0 to 3 wt% at least one alkaline-earth metal.

8. The method according to claim 7,
**characterized in that**
the corrosion protection layer (4) is applied by at least one process selected from the group comprising plasma spraying, suspension plasma spraying, low-pressure plasma spraying, physical vapor deposition, chemical vapor deposition, melting, hot-melt coating, brushing, rolling, spraying, and sintering.

## Revendications

1. Composant d'une turbomachine constitué d'un matériau composite (5) avec une matrice de céramique et une couche de protection anticorrosion (4),
**caractérisé en ce que** :
la couche de protection anticorrosion comprend :
50 à 80 % en poids de silicium,
12 à 30 % en poids d'azote,
2 à 8 % en poids d'oxygène,
2 à 8 % en poids d'aluminium et
0 à 3 % en poids d'au moins un métal alcalinoterreux.

2. Composant selon la revendication 1,
**caractérisé en ce que** :
la couche de protection anticorrosion (4) comprend :
60 à 70 % en poids, en particulier 64 à 66 % en poids de silicium,
15 à 25 % en poids, en particulier 18 à 22 % en poids d'azote,
3 à 7 % en poids, en particulier 4 à 6 % en poids d'oxygène,
3 à 7 % en poids, en particulier 4 à 6 % en poids d'aluminium et
0,1 à 2,5 % en poids, en particulier 1 à 2 % en poids d'au moins un métal alcalinoterreux.

3. Composant selon l'une quelconque des revendications précédentes,
**caractérisé en ce que** :
le matériau composite (5) avec la matrice de céramique est un matériau composite renforcé de fibres avec des fibres céramiques incorporées.

4. Composant selon l'une quelconque des revendications précédentes,
**caractérisé en ce que** :
la matrice de céramique est formée d'au moins un composant du groupe qui comprend le carbone, le carbure de silicium, l'oxyde d'aluminium et la mullite.

5. Composant selon l'une quelconque des revendications 3 ou 4,
**caractérisé en ce que** :
les fibres de céramique sont formées d'au moins un composant du groupe qui comprend le carbone, le carbure de silicium, l'oxyde d'aluminium et la mullite.

6. Composant selon l'une quelconque des revendications précédentes,
**caractérisé en ce que** :
on agence entre le matériau composite (5) et la couche de protection anticorrosion (4) au moins une couche d'adhésif (6) qui est formée en particulier d'un matériau du groupe qui comprend la mullite, le silicium et un mélange du matériau de la couche de protection anticorrosion et de mullite,

7. Procédé de fabrication d'un composant d'une turbomachine, dans lequel un demi-produit est préparé à partir d'un matériau composite avec une matrice de céramique,
**caractérisé en ce que** :
sur le demi-produit est déposée une couche de protection anticorrosion (4) qui comprend :
50 à 80 % en poids de silicium,
12 à 30 % en poids d'azote,
2 à 8 % en poids d'oxygène,
2 à 8 % en poids d'aluminium et
0 à 30 % en poids d'au moins un métal alcalinoterreux.

8. Procédé selon la revendication 7,
**caractérisé en ce que** :
la couche de protection anticorrosion (4) est appliquée par au moins un procédé du groupe qui comprend une projection au plasma, une projection au plasma en suspension, une projection au plasma à basse pression, un dépôt en phase gazeuse physique, un dépôt en phase gazeuse chimique, une fusion, une immersion à chaud, un couchage, un laminage, une pulvérisation et un frittage.
